# EUROPÄISCHE PATENTSCHRIFT

(11) **EP 2 727 138 B1**
(45) Veröffentlichungstag und Bekanntmachung des Hinweises auf die Patenterteilung: **25.03.2020**
(21) Anmeldenummer: 12748380.8
(22) Anmeldetag: 02.07.2012
(51) Int. Cl.: H01L 21/683

(54) **VORRICHTUNG ZUM HALTEN EINES FLÄCHIGEN SUBSTRATS**
DEVICE FOR HOLDING A PLANAR SUBSTRATE
DISPOSITIF POUR FIXER UN SUBSTRAT PLAT

(30) Priorität: 01.07.2011 AT 9692011
(43) Veröffentlichungstag der Anmeldung: 07.05.2014
(73) Patentinhaber: Mechatronic Systemtechnik GmbH, 9500 Villach (AT)
(72) Erfinder: OREMUS, Alexander, A-9500 Villach (AT)
(74) Vertreter: Jell, Friedrich
(86) Internationale Anmeldenummer: PCT/AT2012/050092
(87) Internationale Veröffentlichungsnummer: WO 2013/003877

(56) Entgegenhaltungen:
- EP-A1- 0 860 861
- JP-A- 57 177 536
- US-A1- 2003 008 602
- US-A1- 2007 026 772

## Beschreibung

Die Erfindung betrifft Vorrichtung zum Halten eines flächigen Substrats, insbesondere für einen Wafer und/oder eWLB, mit einer für das Substrat eine Auflagefläche ausbildenden Auflage, die wenigstens eine im Bereich der Auflagefläche für das Substrat vorgesehene Ausnehmung aufweist, mit wenigstens einem mit einer Ausnehmung strömungsverbundenen Haltemittel zur Befestigung des Substrats an der Vorrichtung mit Hilfe eines zwischen Auflage und Substrat erzeugten Unterdrucks und mit einer Dichtung, wobei wenigstens eine Ausnehmung die elastische Dichtung aufweist, die von einer dem Rand der Ausnehmung vorstehenden in eine gegenüber dem Rand der Ausnehmung zurückgezogene bzw. höchsten mit diesem übereinstimmende Lage bewegbar ausgebildet ist und die mit der Ausnehmung, die mit dem Haltemittel strömungsverbundenen ist, zum vollflächigen Ansaugen des Substrats an die Auflage zusammenwirkt.

Aus dem Stand der Technik sind "Vakuum Chuck" bzw. Halterungen für Wafer bzw. andere Substrate bekannt (US2010/0013169A1), die diese mit Hilfe von Unterdruck binden bzw. an deren Auflage festhalten. Oftmals erfüllen diese auch die Aufgabe, die Substrate in eine plane Erstreckung zu ziehen. Zu diesem Zweck weist die Auflagefläche der Auflage Ausnehmungen auf, die zur Erzeugung eines Unterdrucks mit Haltemitteln strömungsverbunden sind. Damit können verzogene Substrate plan gezogen werden - vergleichsweise stark verzogene Substrate werden zusätzlich mit Druckluft beaufschlagt, um diese auf die Auflagefläche zu drücken und damit ein vollflächiges Ansaugen der Substrate an die Halterung zu ermöglichen. Derartige Druckluftkonstruktionen sind konstruktiv aufwendig und weisen außerdem ein erhöhtes Risiko für Verunreinigung der druckluftbeaufschlagten Substratoberfläche auf, was nachteilig zu einer Beschädigung der Wafer bzw. eWLB ("Embedded Wafer Level Ball Grid Array") führen kann.

Weiter sind Saugnapfe zum Halten von Wafern bekannt (US6517130B1), die in einer Ausnehmung einer eine Auflagefläche ausbildenden Auflage gelagert sind. Diese Saugnapfe sind an einer Unterdruckquelle angeschlossen und können sich mit Ihrer Napfdichtung unter den Rand der Auflagefläche zurückziehen. Vergleichsweise stark verzogene Substrate können damit nicht vollflächig an die Auflagefläche angesaugt werden, was die Verwendbarkeit der Saugnapfe einschränkt.

Eine Vorrichtung zum Halten eines Wafers nach dem Oberbegriff des Anspruchs 1 ist aus der US2007/0026772A1 bekannt.

Die Erfindung hat sich daher die Aufgabe gestellt, eine Vorrichtung zum Halten eines flächigen Substrats der eingangs geschilderten Art derart auf konstruktiv einfache Weise zu verbessern, dass damit vergleichsweise stark verzogene Substrate in eine bestimmte Form gebracht werden können und dabei trotzdem die Gefahr der Beschädigung der Substrate klein bleibt.

Die Erfindung löst die gestellte Aufgabe dadurch, dass die Dichtung als Schlauchdichtung ausgeführt ist, wobei die im Querschnitt kegelförmig verlaufende Dichtung zwei gleiche Biegeschenkel aufweist, um eine in Kipprichtung freie Kippbewegung der Dichtung zu ermöglichen.

Ist die Dichtung als Schlauchdichtung ausgeführt, dann kann außerdem die Verformbarkeit der Dichtung ausgenützt werden, um für eine geringe Belastung des Substrats zu sorgen. Außerdem können damit die Abmessungen der Ausnehmung für die Dichtung gering gehalten und damit ein Kostenvorteil in der Herstellung ermöglicht werden.
Weist die im Querschnitt kegelförmig verlaufende Dichtung zwei gleiche Biegeschenkel auf, kann eine in Kipprichtung freie Kippbewegung ermöglicht werden. Damit kann je nach Verlauf des Substrats eine Kippbewegung in die eine oder in eine dazu entgegengesetzte Kipprichtung vollzogen werden, was die universale Verwendbarkeit der Vorrichtung für unterschiedlichste Substrate erhöhen kann. Weist die Auflage wenigstens eine Ausnehmung mit einer elastischen Dichtung auf, die von einer dem Rand der Ausnehmung vorstehenden in eine gegenüber dem Rand der Ausnehmung zurückgezogene bzw. höchsten mit diesem Rand übereinstimmende Lage bewegbar ausgebildet ist, dann kann die Gefahr einer Beschädigung des Substrats durch eine eventuelle punktuelle Verformung des Substrats im Bereich der Dichtung gering gehalten werden, weil sich die Dichtung unter die Auflagefläche bzw. den Rand der Ausnehmung zurückziehen kann, wenn das Substrat durch Unterdruck an die Auflagefläche angezogen wird. Wenn nun zusätzlich diese Dichtung mit der Ausnehmung zum vollflächigen Ansaugen des Substrats an die Auflage zusammenwirkt, kann durch die vorstehende Dichtung auch ein vergleichsweise stark von der gewünschten geometrischen Form abweichendes Substrat von der Vorrichtung bzw. Halterung aufgenommen und ausreichend festgehalten werden. Die Dichtung kann nämlich so Abstände zwischen Auflagefläche und Substrat ausgleichen bzw. überbrücken und für einen gasdichten Abschluss sorgen. Selbst vergleichsweise starke Durchbiegungen (Bow), Welligkeiten (Warp), abweichende Ebenheiten (Flattness) und/oder Dickenabweichungen (Total Thickness Variation) am Substrat sind dadurch ausgleichbar, wodurch ein sicherer Halt des Substrats an der Vorrichtung gewährleistet werden kann. Hinzu kommt, dass starke geometrische Abweichungen auch ein vollflächiges Ansaugen des Substrats an die Auflage nicht behindern können, so dass jegliche Substrate standfest in eine gewünschte, durch die Auflage vorbestimmte Erstreckung gebracht werden können. Die Vorrichtung kann sich daher insbesondere gegenüber dem Stand der Technik dadurch auszeichnen, dass auf konstruktiv einfache Weise eine vergleichsweise hohe geometrische Toleranzfähigkeit mit einer verminderten Beschädigungsgefahr an der empfindlichen Substratseite genutzt werden kann und es trotzdem möglich ist, Substrate in eine gewünschte Form zu bringen bzw. zu richten, was beispielsweise ein Planziehen und/oder auch ein Ausrichten sein kann. Dies kann insbesondere bei verzogenen bzw. verbogenen Substraten vergleichsweise vorteilhaft sein.

Im Allgemeinen wird darauf hingewiesen, dass die Dichtung auch in einer Ausnehmung vorgesehen sein kann, die mit Haltemitteln strömungsverbunden ist, um zwischen Substrat und Auflage Unterdruck zu erzeugen. Eine Ausnehmung kann daher zwei technische Funktionen erfüllen, einerseits eine Haltefunktion und andererseits auch eine technische Funktion hinsichtlich des vorstehend Angeführten. Weiter wird im Allgemeinen erwähnt, dass unter Wafer kreisrunde oder quadratische Substrate für elektronische Bauelemente, unter anderem für die Mikroelektronik, Photovoltaik und/oder Mikrosystemtechnik verstanden werden können. Der Begriff Wafer kann daher auch künstlich hergestellte Wafer, wie zum Beispiel WLB, eWLB oder dergleichen, mitumfassen.

Konstruktive Einfachheit kann sich ergeben, wenn die elastische Dichtung durch das Substrat passiv bewegbar ausgebildet ist, zumal die Bewegungskräfte zum Abtauchen der Dichtung in eine für die Form des Substrats störungsfreie Lage mit Hilfe des Ansaugens des Substrats miterzeugt werden können.

Bevorzugt sind die Ausnehmungen über die Auflage verteilt angeordnet, um damit ein vollflächiges Ansaugen des Substrats verbessern zu können. Außerdem kann damit eine lokal erhöhte mechanische Belastung der Substrate beim Ansaugen gering gehalten werden. Eine besonders standfeste Vorrichtung kann damit geschaffen werden.

Besonders günstige Ansaugverhältnisse können sich ergeben, wenn die Ausnehmung mit der Dichtung einen geschlossenen Konturenverlauf aufweist.

Besonders günstige Verhältnisse zum Befestigen des Substrats an der Vorrichtung können sich ergeben, wenn die Dichtung im Wesentlichen die Unterdruck aufweisende Ausnehmung der Auflage umfasst. Ebenso kann dadurch die Toleranz der Vorrichtung gegenüber verformte, zum Beispiel verzogene bzw. verbogene, Substrate erhöht werden, da vergrößerte Dichtflächen mit dem Substrat einen erweiterten gasdichten Anschluss ausbilden können. Umfasst die Dichtung die Ausnehmung zum Ansaugen des Substrats vollständig, dann kann ein geschlossener Saugbereich ermöglicht werden, so dass selbst bei vergleichsweise stark verformten Substraten mit verminderten Druckverhältnissen eine sichere Befestigung möglich werden kann. Die Vorrichtung ist daher nicht nur besonders standfest gegenüber Abweichungen in der Geometrie des Substrats sondern kann auch mit verminderten Belastungen Beschädigungen am Substrat vermeiden.

Die Toleranz gegenüber geometrischen Abweichungen am Substrat kann noch weiter erhöht werden, wenn die Ausnehmung für die Dichtung die Auflagefläche in zwei Auflageflächenanteile trennt.

Schließt die Ausnehmung für die Dichtung an einen randseitigen Auflageflächenanteil an, so kann das Substrat bis in seinen Randbereich in eine gewünschte Form gebracht werden. Vergleichsweise große Verbiegungen bzw. Verwerfungen, die insbesondere in den Randbereichen des Substrats zu Handhabungsproblemen führen können, sind so ausgleichbar.

Einfache Konstruktionsverhältnisse können sich ergeben, wenn die Dichtung aufweisende Ausnehmung und mindestens eine mit dem Haltemittel strömungsverbundene Ausnehmung konzentrisch verlaufen. Außerdem ist die Herstellung einer derartigen Vorrichtung vergleichsweise einfach durchführbar, so dass eine kostengünstige Vorrichtung geschaffen werden kann.

Konstruktiv einfach ist die Dichtung mit dem Boden der Ausnehmung stoffschlüssig verbunden. Insbesondere kann durch dieses Zurücksetzen der Verbindungsmittel vermieden werden, dass diese zu einer Beschädigung des Substrats führen können. Eine besonders sichere Vorrichtung kann damit geschaffen werden.

Um vergleichsweise große Substrate samt deren Verwerfungen sicher an der Vorrichtung zu befestigen bzw. deren geometrischen Abweichungen zu kompensieren, kann die Auflage mehrere, die Auflage in mehrere Auflageflächenanteile trennende Ausnehmungen mit Dichtungen aufweisen. Konstruktiv einfach können diese Ausnehmungen radial zueinander versetzt verlaufen. Zwischen diesen Ausnehmungen mit Dichtungen können weitere Ausnehmungen vorgesehen sein, die gemeinsam mit einem Haltemittel strömungsverbunden sind.

Ist wenigstens eine Ausnehmung eines Auflageflächenanteils getrennt von den anderen Ausnehmungen mit dem Haltemittel strömungsverbunden, dann können beispielsweise derart unterschiedliche Ansaugdrücke zwischen Auflage und Substrat eingebracht werden, dass damit ein besonders schonendes Richten des Substrats ermöglicht werden kann. Ein vorteilhaftes Planziehen bzw. Ausrichten von Substraten kann sich so selbst bei stark verzogenen bzw. verbogenen Substraten ergeben.

In den Figuren ist beispielsweise der Erfindungsgegenstand anhand mehrerer Ausführungsbeispiele dargestellt. Es zeigen
- Fig. 1: eine Seitenansicht auf eine erste Vorrichtung mit Substrat in Schnittansicht,
- Fig. 2: eine vergrößerte Detailansicht der Fig. 1,
- Fig. 3: eine Draufsicht auf die Vorrichtung nach Fig. 1 ohne Substrat und
- Fig. 4: eine abgerissene Schnittansicht einer weiteren Vorrichtung zum Halten eines Substrats.

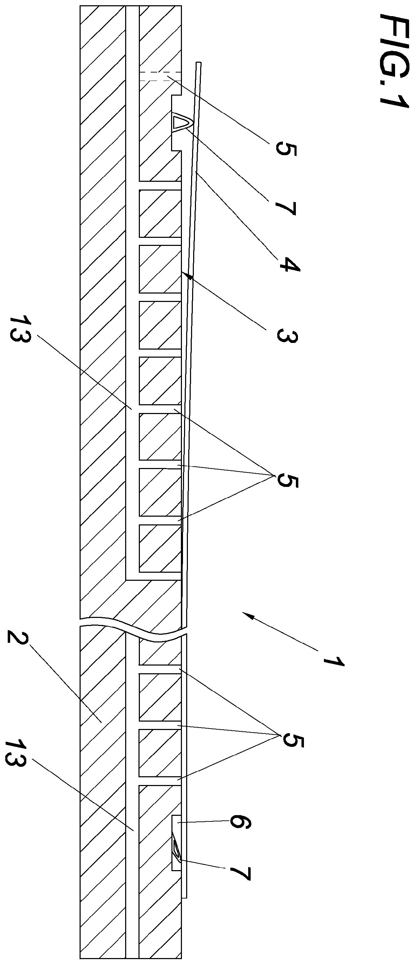

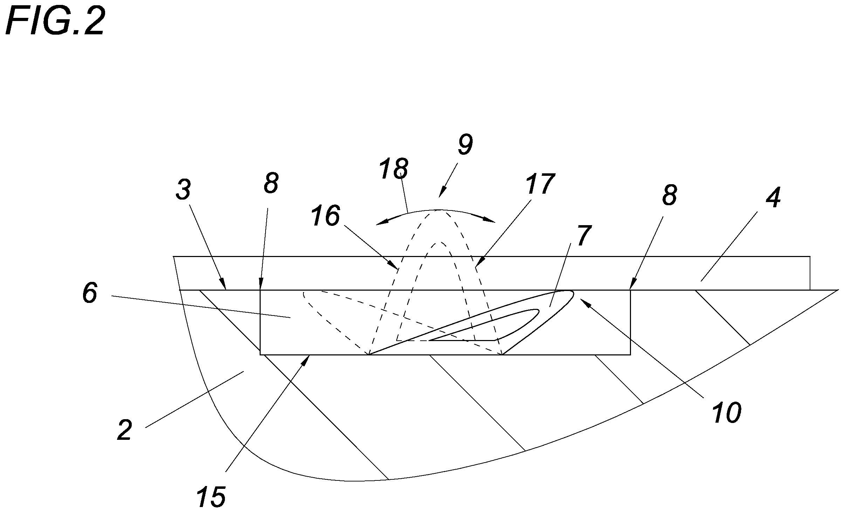

Die beispielsweise nach Fig. 1 dargestellte Vorrichtung 1 weist eine Auflage 2 auf, die eine Auflagefläche 3 für ein flächiges Substrat 4 insbesondere einen eWLB ausbildet. Wie nach Fig. 1 erkannt werden kann, ist das Substrat 4 sphärisch verbogen und berührt daher nur teilweise die Auflagefläche 3. Um nun das Substrat 4 an der Vorrichtung zu befestigen bzw. dieses in eine gewünschte Erstreckung zu bringen, weist die Auflage 2 Ausnehmungen 5 auf, die mit einer Unterdruckleitung 13 von ansonsten nicht näher dargestellten Haltemitteln zu Erzeugung von Unterdruck strömungsverbunden sind. Damit kann das Substrat 4 an die Auflagefläche 3 angesaugt und befestigt werden, wodurch auch eine eventuell vom Soll abweichende Form des Substrats 4 an den Verlauf der Auflagefläche 3 angepasst wird. Um jedoch auch vergleichsweise starke sphärische Verbiegungen (konkave und/oder konvexe Ausbildung) aufnehmen, befestigen bzw. planformen zu können, weist die Auflage 2 eine zu den Ausnehmung 5 weitere Ausnehmung 6 mit einer elastischen Dichtung 7 auf. Damit ist ein gasdichter Anschluss der Auflage 2 mit dem Substrat 4 gewährleistet, so dass das Substrat 4 mit Hilfe von Unterdruck an die Auflage 2 angezogen werden kann. Das Besondere an dieser Dichtung 7 ist jedoch, dass diese Dichtung 7 von einer gegenüber dem Rand 8 der Ausnehmung 6 vorstehenden Lage 9 in eine gegenüber dem Rand 8 der Ausnehmung 6 zurückgezogenen Lage 9 bzw. höchstens mit diesem Rand 8 gleichen Lage 10 bewegbar ausgebildet ist. Die unterschiedlichen Lagen 9 und 10 sind insbesondere der Fig. 2 zu entnehmen. Durch diese sich zurückziehende Dichtung 7 können nun Belastungen des Substrats 4 beim Anziehen dieses Substrats 4 an die Auflagefläche 3 vernachlässigt werden, was nicht nur eine besonders tolerant gegenüber Durchbiegungen (Bow), Welligkeiten (Warp), abweichende Ebenheiten (Flattness) sowie Dickenabweichungen (Total Thickness Variation) des Substrats 4 arbeitende Vorrichtung schaffen, sondern auch eine vergleichsweise geringe Gefahr an Beschädigungen am Substrat 4 aufweisen kann. Die erfindungsgemäße Vorrichtung eignet sich daher insbesondere für vergleichsweise stark verzogene bzw. verbogene Substrate 4 einerseits zu deren sicheren Halterung und andererseits zu deren Richten auf eine gewünschte geometrische Form, weil diese Ausnehmung 6 mit der Ausnehmung 5 zusammenwirkt, ein vollflächiges Ansaugen des Substrats 4 an die Auflage 2 zu ermöglichen.

Die elastische Dichtung 7 wird beim Anziehen des Substrats 4 an die Auflagefläche 3 passiv bewegt, so dass das Substrat 4 die Dichtung 7 elastisch verformt. Auf weitere konstruktive Maßnahmen zum Zurückziehen der Dichtung 7 kann so verzichtet werden, was eine kostengünstige Vorrichtung 1 schaffen kann.

Die Ausnehmungen 5 sind über die Auflage 2 verteilt angeordnet, was nicht nur den Saugdruck vergleichmäßigt sondern auch ein vollflächiges Ansaugen sicherstellt.

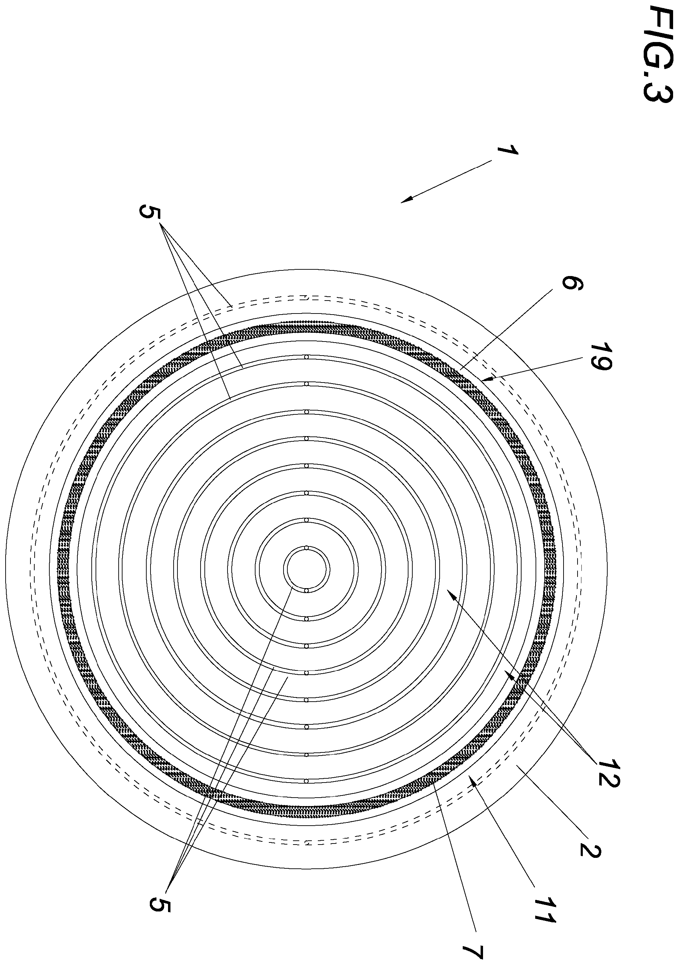

Gemäß Fig. 3 ist ersichtlich, dass die Dichtung 7 vollständig die Unterdruck aufweisende Ausnehmung 5 der Auflage 2 umfasst, und bildet somit einen geschlossenen Konturenverlauf 19 aus. Damit kann ein besonders gasdichter Anschluss zwischen Vorrichtung 1 und Substrat 4 geschaffen werden. Außerdem kann so die Toleranz der Vorrichtung 1 gegenüber geometrischen Abweichungen am Substrat 4 noch weiter erhöht werden.

Eine besondere Planheit des befestigten Substrats 4 selbst im Randbereich des Substrats 4 kann geschaffen werden, wenn die Ausnehmung für die Dichtung 7 an einen randseitigen Auflageflächenanteil 11 anschließt. Da die Dichtung dadurch die Auflagefläche 3 in wenigstens zwei Auflageflächenanteile 11 und 12 trennt kann die äußere Auflagefläche 11 auch als Loslager ein Anziehen des Substrats 4 an die Auflagefläche 11 verbessern.

Die Ausnehmungen 5 und 6 verlaufen konzentrisch. Die Dichtung 7 ist für eine hohe Verformbarkeit als Schlauchdichtung ausgeführt und mit dem Boden 15 der Ausnehmung 6 stoffschlüssig verbunden, insbesondere verklebt. Damit stellt sich ein kegelförmiger Querschnittsverlauf der Dichtung 7 ein, die mit ihren beiden Schenkeln 16 und 17 eine freie Kippbewegung 18 durchführen kann, die je nach aufzunehmendem Substrat in die eine oder in die andere Kipprichtung sein kann. Damit ist die Vorrichtung 1 besonders tolerant gegenüber verschieden verformten Substraten 4.

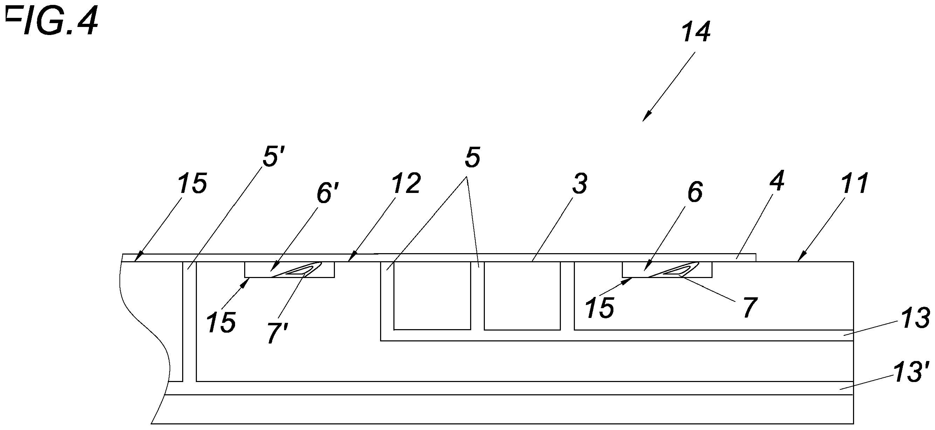

Für größere Substrate 4 kann die Auflage 2 mehrere radial zueinander versetzte Ausnehmungen 6 mit Dichtungen 7 aufweisen, was nach Fig. 4 näher dargestellt worden ist. Dadurch können mehrere Auflageflächenanteile 11, 12 und 14 geschaffen werden. Vorteilhaft verlaufen die Ausnehmungen 6, 6' radial zueinander versetzt.

Die Ausnehmungen 5' sind über eine eigene Unterdruckleitung 13' mit dem Haltemittel strömungsverbunden. Damit können zwischen den Ausnehmungen 6, 6' mit Dichtungen 7, 7' auch Ausnehmungen 5', 5 vorgesehen werden, die mit unterschiedlichen Unterdruckverhältnissen beaufschlagbar sind. Ein vergleichsweise schonendes Halten und/oder Richten von Substraten 4 kann damit eingestellt bzw. gewährleistet werden.

## Patentansprüche

1. Vorrichtung zum Halten eines flächigen Substrats (4), insbesondere für einen Wafer und/oder eWLB, mit einer für das Substrat (4) eine Auflagefläche (3) ausbildenden Auflage (2), die wenigstens eine im Bereich der Auflagefläche (3) für das Substrat (4) vorgesehene Ausnehmung (5, 6) aufweist, mit wenigstens einem mit einer Ausnehmung (5) strömungsverbundenen Haltemittel (13) zur Befestigung des Substrats (4) an der Vorrichtung (1) mit Hilfe eines zwischen Auflage (2) und Substrat (4) erzeugten Unterdrucks und mit einer Dichtung (7), wobei wenigstens eine Ausnehmung (6) die elastische Dichtung (7) aufweist, die von einer dem Rand (8) der Ausnehmung (6) vorstehenden in eine gegenüber dem Rand (8) der Ausnehmung (6) zurückgezogene bzw. höchsten mit diesem übereinstimmende Lage (9, 10) bewegbar ausgebildet ist und die mit der Ausnehmung (5), die mit dem Haltemittel (13) strömungsverbundenen ist, zum vollflächigen Ansaugen des Substrats (4) an die Auflage (2) zusammenwirkt, **dadurch gekennzeichnet, dass** die Dichtung (7) als Schlauchdichtung ausgeführt ist, wobei die im Querschnitt kegelförmig verlaufende Dichtung (7) zwei gleiche Biegeschenkel (16, 17) aufweist, um eine in Kipprichtung freie Kippbewegung (18) der Dichtung (7) zu ermöglichen.

2. Vorrichtung nach Anspruch 1, **dadurch gekennzeichnet, dass** die elastische Dichtung (7) durch das Substrat (4) passiv bewegbar ausgebildet ist.

3. Vorrichtung nach Anspruch 1 oder 2, **dadurch gekennzeichnet, dass** die Ausnehmungen (5) über die Auflage (2) verteilt angeordnet sind.

4. Vorrichtung nach Anspruch 1, 2 oder 3, **dadurch gekennzeichnet, dass** die Ausnehmung (6) mit der Dichtung (7) einen geschlossenen Konturenverlauf (19) aufweist.

5. Vorrichtung nach einem der Ansprüche 1 bis 4, **dadurch gekennzeichnet, dass** die Dichtung (7) im Wesentlichen, bevorzugt vollständig, die Unterdruck aufweisende Ausnehmung (5) der Auflage (2) umfasst.

6. Vorrichtung nach einem der Ansprüche 1 bis 5, **dadurch gekennzeichnet, dass** die Ausnehmung (6) für die Dichtung (7) die Auflagefläche (3) in zwei Auflageflächenanteile (11, 12) trennt.

7. Vorrichtung nach Anspruch 6, **dadurch gekennzeichnet, dass** die Ausnehmung (6) für die Dichtung (7) an einen randseitigen Auflageflächenanteil (11) anschließt.

8. Vorrichtung nach einem der Ansprüche 1 bis 7, **dadurch gekennzeichnet, dass** wenigstens eine die Dichtung (7) aufweisende Ausnehmung (6) und mindestens eine mit dem Haltemittel strömungsverbundene Ausnehmung (5) konzentrisch verlaufen.

9. Vorrichtung nach einem der Ansprüche 1 bis 8, **dadurch gekennzeichnet, dass** die Dichtung (7) mit dem Boden (15) der Ausnehmung (6) stoffschlüssig verbunden ist.

10. Vorrichtung nach einem der Ansprüche 1 bis 9, **dadurch gekennzeichnet, dass** die Auflage (2) mehrere, die Auflage (2) in mehrere Auflageflächenanteile (11, 12, 14) trennende Ausnehmungen (6, 6') mit Dichtungen (7, 7') aufweist, welche Ausnehmungen (6, 6') insbesondere radial zueinander versetzt verlaufen.

11. Vorrichtung nach Anspruch 10, **dadurch gekennzeichnet, dass** wenigstens eine Ausnehmung (5 bzw. 5') eines Auflageflächenanteils (11, 12 oder 14) getrennt von den anderen Ausnehmungen (5' bzw. 5) mit dem Haltemittel (13) strömungsverbunden ist.

## Claims

1. Apparatus for holding a planar substrate (4), more particularly for a wafer and/or eWLB, having a support (2) that forms a supporting surface (3) for the substrate (2), which has at least one recess (5) provided in the region of the supporting surface (3) for the substrate (2), and having at least one holding means (13) connected with an recess (5), in terms of flow, for fastening the substrate (2) onto the apparatus (1), using a partial vacuum generated between support (2) and substrate (4), and with an elastic seal (7), wherein at least one recess (6) has the elastic seal (7), which is configured so that it can be moved from a position projecting beyond the edge (8) of the recess (6) into a position pulled back in relation to the edge (8) of the recess (6) or at most agreeing with this position (9, 10), and which works together with the recess (5), which is connected with the holding mean (13) in terms of flow, to draw the substrate (4) against the support (2) over its full area, by suction, **characterized in that** the seal (7) is structured as a tubular seal, wherein seal (7) which runs conically in cross-section, has two equal bending shanks (16, 17), in order to allow a tilting movement (18) of the seal (7) that is free in the tilting direction.

2. Apparatus according to claim 1, **characterized in that** the elastic seal (7) is configured so that it can be passively moved by the substrate (7).

3. Apparatus according to claim 1 or 2, **characterized in that** the recesses (5) are disposed distributed over the support (2).

4. Apparatus according to claim 1, 2 or 3, **characterized in that** the recess (6) having the seal (7) forms a closed contour progression (19).

5. Apparatus according to one of claims 1 to 4, **characterized in that** the seal (7) essentially, preferably completely surrounds the recess (5) of the support (2) that has a partial vacuum.

6. Apparatus according to one of claims 1 to 5, **characterized in that** the recess (6) for the seal (7) divides the supporting surface (3) into two supporting surface portions (11, 12).

7. Apparatus according to claim 6, **characterized in that** the recess (6) for the seal (7) follows an edge-side supporting surface portion (11).

8. Apparatus according to one of claims 1 to 7, **characterized in that** at least one recess (6) having the seal (7) and at least one recess (5) connected with the holding means, in terms of flow, run concentrically.

9. Apparatus according to one of claims 1 to 8, **characterized in that** the seal (7) is connected with the bottom (15) of the recess (6) with a firm bond.

10. Apparatus according to one of claims 1 to 9, **characterized in that** the support (2) has multiple recesses (6, 6') having seals (7, 1'), which divide the support (2) into multiple supporting surface portions (11, 12, 14), which recesses (6, 6') more particularly run radially offset from one another.

11. Apparatus according to claim 10, **characterized in that** at least one recess (5 or 5') of a supporting surface portion (11, 12 or 14) is connected with the holding means (13), in terms of flow, separately from the other recesses (5 or 5').

## Revendications

1. Dispositif destiné à maintenir un substrat plat (4), en particulier pour une plaquette et/ou une puce eWLB, avec un élément d'appui (2) formant une surface d'appui (3) pour le substrat (4), qui présente au moins un évidement (5, 6) prévu dans la zone de la surface d'appui (3) pour le substrat (4), avec au moins un moyen de retenue (13) en liaison fluidique avec un évidement (5) pour la fixation du substrat (4) sur le dispositif (1) à l'aide d'une pression négative générée entre l'élément d'appui (2) et le substrat (4), et avec un joint d'étanchéité (7), dans lequel au moins un évidement (6) présente le joint d'étanchéité élastique (7) qui est conçu mobile entre une position en saillie du bord (8) de l'évidement (6) et une position en retrait par rapport au bord (8) de l'évidement (6) ou qui coïncide tout au plus avec celui-ci et qui coopère avec l'évidement (5) en liaison fluidique avec le moyen de retenue (13) pour l'aspiration en pleine surface du substrat (4) sur l'élément d'appui (2), **caractérisé en ce que** le joint d'étanchéité (7) est réalisé sous la forme d'un joint d'étanchéité tubulaire, le joint d'étanchéité (7) conique en section transversale présentant deux branches de flexion identiques (16, 17) pour permettre un mouvement de basculement libre (18) du joint d'étanchéité (7) dans une direction de basculement.

2. Dispositif selon la revendication 1, **caractérisé en ce que** le joint d'étanchéité élastique (7) est conçu mobile passivement à travers le substrat (4).

3. Dispositif selon la revendication 1 ou 2, **caractérisé en ce que** les évidements (5) sont répartis sur l'élément d'appui (2).

4. Dispositif selon la revendication 1, 2 ou 3, **caractérisé en ce que** l'évidement (6) avec le joint d'étanchéité (7) présente un contour fermé (19).

5. Dispositif selon l'une des revendications 1 à 4, **caractérisé en ce que** le joint d'étanchéité (7) comprend sensiblement, de préférence complètement, l'évidement (5) de l'élément d'appui (2) qui présente une pression négative.

6. Dispositif selon l'une des revendications 1 à 5, **caractérisé en ce que** l'évidement (6) pour le joint d'étanchéité (7) sépare la surface d'appui (3) en deux parties de surface d'appui (11, 12).

7. Dispositif selon la revendication 6, **caractérisé en ce que** l'évidement (6) pour le joint d'étanchéité (7) se raccorde à une partie de surface d'appui périphérique (11).

8. Dispositif selon l'une des revendications 1 à 7, **caractérisé en ce qu'**au moins un évidement (6) présentant le joint d'étanchéité (7) et au moins un évidement (5) en liaison fluidique avec le moyen de retenue s'étendent concentriquement.

9. Dispositif selon l'une des revendications 1 à 8, **caractérisé en ce que** le joint d'étanchéité (7) est relié au fond (15) de l'évidement (6) par une liaison de matière.

10. Dispositif selon l'une des revendications 1 à 9, **caractérisé en ce que** l'élément d'appui (2) présente plusieurs évidements (6, 6') avec des joints d'étanchéité (7, 7') séparant l'élément d'appui (2) en plusieurs parties de surface d'appui (11, 12, 14), lesquels évidements (6, 6') s'étendent en particulier de manière décalée radialement les uns par rapport aux autres.

11. Dispositif selon la revendication 10, **caractérisé en ce qu'**au moins un évidement (5 ou 5') d'une partie de surface d'appui (11, 12 ou 14) est en liaison fluidique avec le moyen de retenue (13) séparément des autres évidements (5' ou 5).
